# EUROPEAN PATENT APPLICATION

(11) **EP 2 983 097 A1**
(43) Date of publication of application: **10.02.2016**
(21) Application number: 15179750.3
(22) Date of filing: 04.08.2015
(51) Int. Cl.: G06F 17/50, G06T 17/20

(54) **SYSTEM AND METHOD OF GENERATING AN AXIALLY STRUCTURED VOLUME MESH FOR SIMULATING DESIGN COMPONENTS**

(30) Priority: 05.08.2014 IN CH38402014
(71) Applicant: Airbus Group India Private Limited, Karnataka, Bangalore (IN)
(72) Inventor: KUMAR, Sunil, Karnataka (IN); ARORA, Prashant, Karnataka (IN); TURAGA, Sriramakrishna, Karnataka (IN)
(74) Representative: Ribeiro, James Michael

(57) **Abstract**

A system and method of generating an axially structured volume mesh for simulating a design component are disclosed. In one embodiment, the axially structured volume mesh having hexahedral cells on boundary layers of the design component and wedges and/or polyhedral cells along length of remaining part of the design component is generated.

## Description

### TECHNICAL FIELD

Embodiments of the present subject matter generally relate to mesh generation, and more particularly, to generating an axially structured volume mesh for simulating design components.

### BACKGROUND

Typically, computational fluid dynamics (CFD) is used to provide simulations of fluid flows. Generally, fluid flow may be simulated by constructing a model of geometry of interest (e.g., a design component) and a fluid flow domain associated with that geometry, then performing calculations to simulate the fluid flow in and around this geometry. In one example, a three dimensional CFD model may use a mesh of cells to represent the fluid flow domain. An existing volume meshing method forms a volume mesh having prism cells near wall region of a design component and tetrahedral cells in remaining part of the design component. However, the volume mesh formed using this method is a high resolution mesh having a large number of cells. In order to reduce the number of cells in the volume mesh, an existing volume meshing method forms a structured volume mesh having O-grid topology cells near wall region and hexahedral cells in remaining part of the design component. However, this method for forming the structured volume mesh is a manual approach and may make a mesh type dependent upon the user's skill and expertise. Another existing volume meshing method forms a structured volume mesh using a sweep algorithm. However, mesh formation for boundary layers using a sweep type mesh may fail when a curvature on driving surfaces is high and also, the boundary layers may not adhere to the near wall region of the design component.

### SUMMARY

A system and method of generating an axially structured volume mesh for simulating design components are disclosed. According to one aspect of the present subject matter, an axially structured volume mesh having hexahedral cells on boundary layers of a design component and wedges and/or polyhedral cells along length of remaining part of the design component is generated.

According to another aspect of the present subject matter, the system includes a processor and a memory coupled to the processor. Further, the memory includes a volume mesh generation module to perform the method described above.

According to yet another aspect of the present subject matter, a non-transitory computer-readable storage medium of generating the axially structured volume mesh for simulating the design components, having instructions that, when executed by a computing system causes the computing system to perform the method described above.

According to yet another aspect of the invention, there is provided a system for generating an axially structured volume mesh for simulating a design component, the system comprising: a processor; and a memory coupled to the processor, wherein the memory comprises a volume mesh generation module, and the volume mesh generation module is configured to: generate the axially structured volume mesh having hexahedral cells on boundary layers of the design component and wedges and/or polyhedral cells along length of remaining part of the design component.

The system and method disclosed herein may be implemented in any means for achieving various aspects. Other features will be apparent from the accompanying drawings and from the detailed description that follow.

### BRIEF DESCRIPTION OF THE DRAWINGS

Various embodiments are described herein with reference to the drawings, wherein:
**FIG. 1** is a flow diagram illustrating an example computer implemented method of generating an axially structured volume mesh for simulating a design component, according to one embodiment;
**FIGS. 2A-2D** are cross-sectional views of an example design component illustrating a method of generation of an axially structured volume mesh, according to one embodiment;
**FIG. 3A** is a perspective view of an axially structured volume mesh generated on an example cylindrical design component with uniform cross-sectional area, according to one embodiment;
**FIGS. 3B** and **3C** are different cross-sectional views of the axially structured volume mesh, shown in **FIG. 3A****,** according to one embodiment;
**FIGS. 4-6** are perspective views of an axially structured volume mesh generated on various cylindrical design components with non-uniform cross-sectional areas, according to one embodiment; and
**FIG. 7** is a block diagram of a computing system of generating an axially structured volume mesh for simulating design components, using the process described with reference to **FIG. 1**, according to one embodiment.

The drawings described herein are for illustration purposes only and are not intended to limit the scope of the present disclosure in any way.

### DETAILED DESCRIPTION

A system and method of generating an axially structured volume mesh for simulating design components are disclosed. In the following detailed description of the embodiments of the present subject matter, references are made to the accompanying drawings that form a part hereof, and in which are shown by way of illustration specific embodiments in which the present subject matter may be practiced. These embodiments are described in sufficient detail to enable those skilled in the art to practice the present subject matter, and it is to be understood that other embodiments may be utilized and that changes may be made without departing from the scope of the present subject matter. The following detailed description is, therefore, not to be taken in a limiting sense, and the scope of the present subject matter is defined by the appended claims.

The term "shell" refers to a two dimensional element in a mesh and the term "cell" refers to a three dimensional element in a mesh.

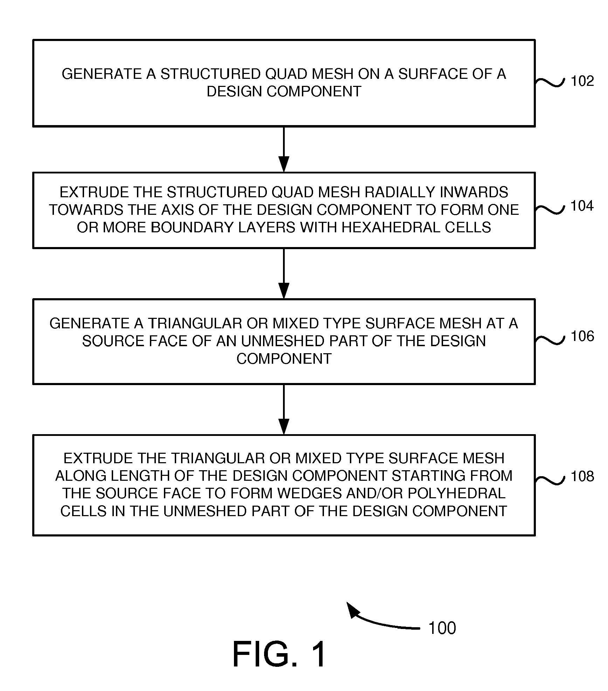

**FIG. 1** is a flow diagram 100 illustrating an example computer implemented method of generating an axially structured volume mesh for simulating a design component, according to one embodiment. For example, the design component includes ducts or bends with uniform or non-uniform cross-sectional areas. For example, a design component can be of any shape, such as cylindrical, oval, eccentric, n-sided (e.g., square, rectangular, and so on) and the like.

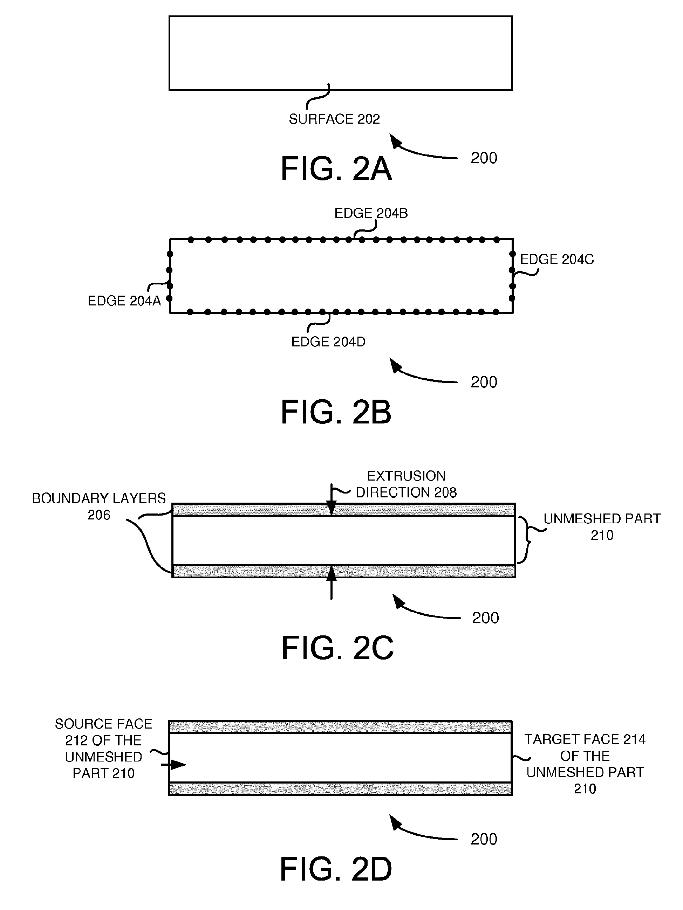

At block 102, a structured quad mesh is generated on a surface of the design component. In one example implementation, node pairs along opposite edges of the design component are identified. The opposite edges include equal number of nodes. The structured quad mesh is then generated on the surface of the design component by joining the identified nodes pairs. The structured quad mesh generated on the surface of the design component includes structured quad shells. **FIG. 2A** illustrates a schematic view of a surface 202 of an example design component 200. **FIG. 2B** illustrates example nodes (shown with bold circles) on edges 204A-D of the design component 200.

At block 104, the structured quad mesh is extruded radially inwards towards the axis of the design component to form one or more boundary layers with hexahedral cells. In one embodiment, faces of the structured quad shells are extruded radially inwards towards the axis of the design component such that the boundary layers with the hexahedral cells are formed. In other words, the faces of the structured quad shells (i.e., two dimensional elements) are extruded into a third dimension, forming the boundary layers with hexahedral cells. For example, the boundary layers are formed based on input parameters, such as a growth ratio, a total number of boundary layers and height of a first boundary layer. The growth ratio is a ratio by which progression of mesh layers is generated in near wall region of the design component. Generally, the input parameters are governed by wall y+ requirements (i.e., requirements used for determining mesh layer spacing), boundary layer thickness, transition from the boundary layers to remaining part of the design component, quality of the boundary layer mesh and so on. **FIG. 2C** illustrates forming example boundary layers 206 by extruding the structured quad mesh radially inwards (e.g., as shown by extrusion direction 208). Further, **FIG. 2C** shows an unmeshed part 210 of the design component after forming the boundary layers 206. The unmeshed part 210 refers to a portion of the design component 200 excluding the boundary layers 206.

At block 106, a triangular or mixed type surface mesh is generated at a source face of the unmeshed part of the design component. Example source face 212 of the unmeshed part 210 of the design component 200 is shown **FIG. 2D****.** In one example, the triangular surface mesh generated at the source face of the unmeshed part includes triangular shells. In another example, the mixed type surface mesh generated at the source face of the unmeshed part includes, but not limited to, triangles, quadrilaterals and poly type shells (i.e., n-sided shells).

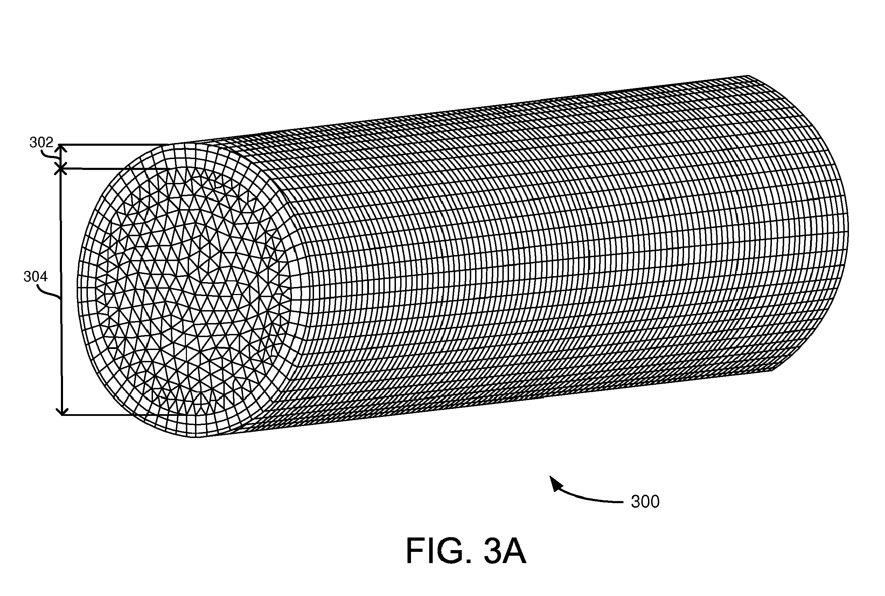

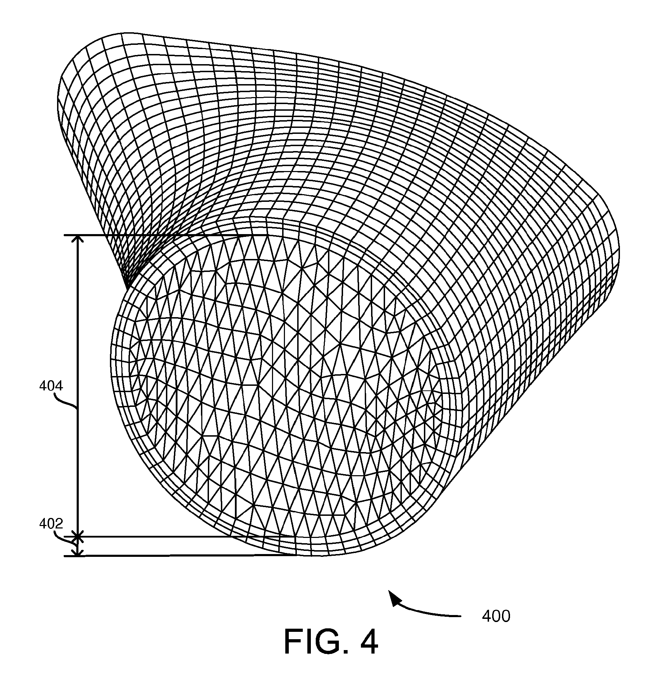

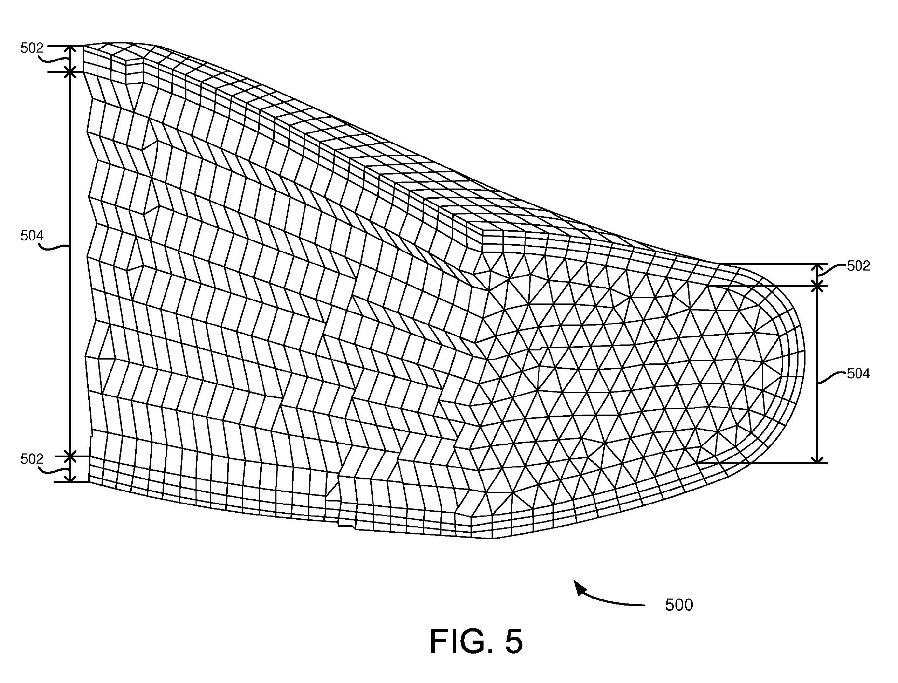

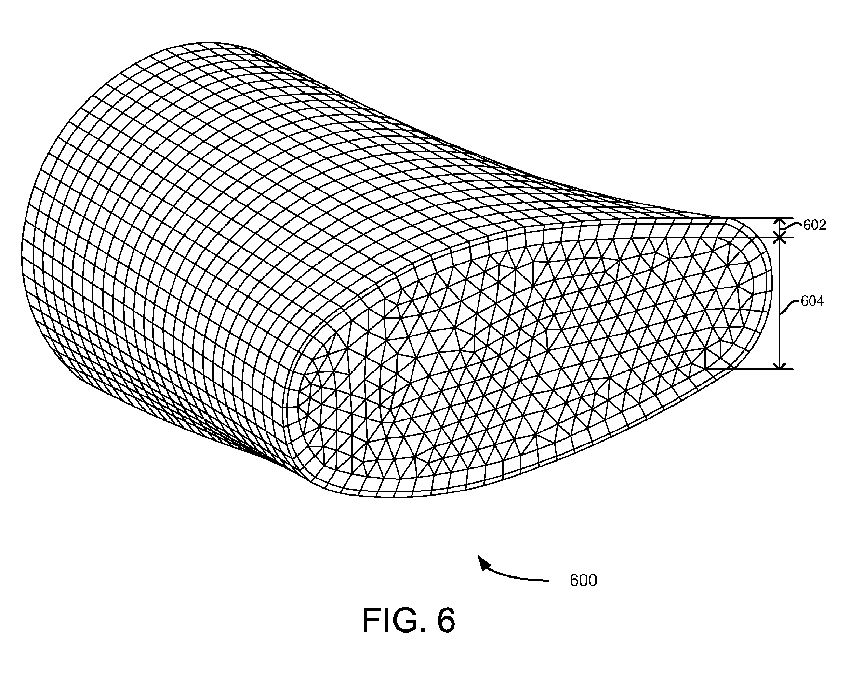

At block 108, the triangular or mixed type surface mesh is extruded along length of the design component starting from the source face to form wedges and/or polyhedral cells in the unmeshed part of the design component. In other words, the triangular or mixed type surface mesh at the source face becomes the master which is being treated as the driven surface mesh along the face of hexahedral subsurface, to create a mapped mesh with inlet as the source face and outlet as a target face (i.e., a target face 214 of the unmeshed part 210 shown in **FIG. 2D**). In one example implementation, faces of the triangular shells (i.e., two dimensional elements) are extruded into a third dimension to generate the wedges and/or polyhedral cells in the unmeshed part of the design component. Example axially structured volume mesh generated, using the above described method, on an example cylindrical design component with uniform cross-sectional area is shown in **FIGS. 3A-3C****.** Example axially structured volume mesh generated, using the above described method, on various cylindrical design components with non-uniform cross-sectional areas is shown in **FIGS. 4-6**.

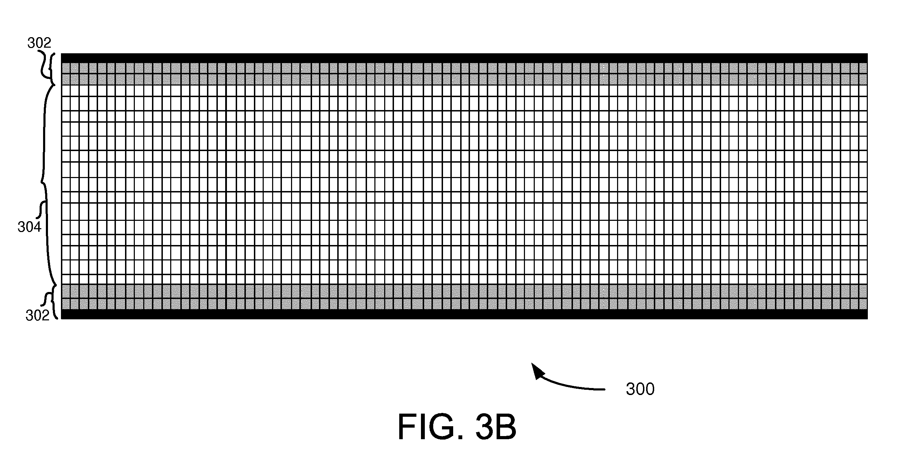

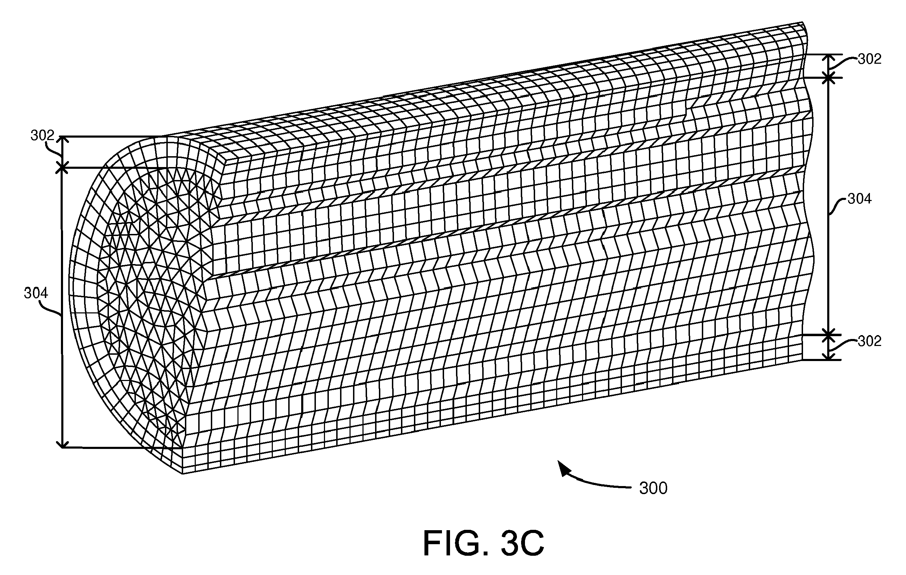

**FIG. 3A-3C** shows an example axially structured volume mesh generated using the method described in **FIG. 1****.** Particularly, **FIG. 3A** is a perspective view of an axially structured volume mesh generated on an example cylindrical design component 300 with uniform cross-sectional area, according to one embodiment. As shown in **FIG. 3AB****,** the axially structured volume mesh include hexahedral cells on boundary layers 302 of the cylindrical design component 300 and wedges along length of remaining part 304 of the cylindrical design component 300. The axially structured volume mesh is a structured mesh in the axial direction of the boundary layers 302 and a core region 304 (i.e., the remaining part of the cylindrical design component). **FIGS. 3B** and **3C** are different cross-sectional views of the axially structured volume mesh, shown in **FIG. 3A**, according to one embodiment. Particularly, **FIG. 3B** is the cross-sectional view of the axially structured volume mesh when the axially structured volume mesh is zoomed-in. As shown in **FIGS. 3B** and **3C**, the axially structured mesh is filled in entire volume starting from the boundary layers 302 to the core region 304, both of them connected node-to-node.

**FIGS. 4-6** illustrates an example axially structured volume mesh generated using the method described in **FIG. 1****.** Particularly, **FIGS. 4-6** are perspective views of an axially structured volume mesh generated on various cylindrical design components 400, 500 and 600 with non-uniform cross-sectional areas, according to one embodiment. As shown in **FIGS. 4-6**, the axially structured volume mesh include hexahedral cells on boundary layers 402, 502, and 602 of the cylindrical design components 400, 500, and 600, respectively, and wedges along length of remaining part 404, 504 and 604 of the cylindrical design components 400, 500, and 600, respectively.

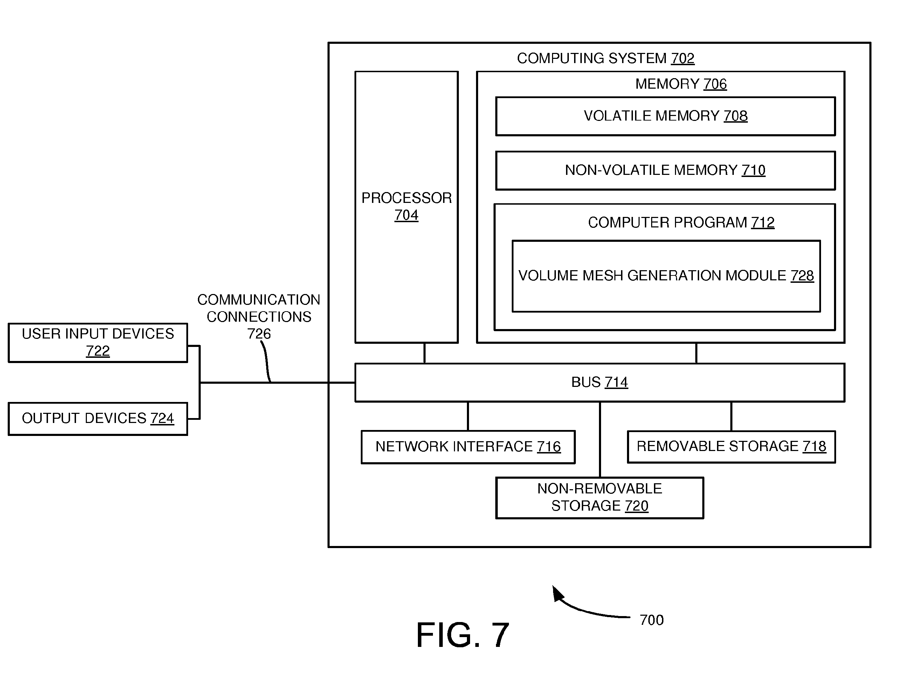

Referring now to **FIG. 7**, which illustrates a block diagram 700 of a computing system of generating an axially structured volume mesh for simulating design components, using the process described with reference to **FIG. 1** and the following discussions are intended to provide a brief, general description of a suitable computing environment in which certain embodiments of the inventive concepts contained herein are implemented.

The computing system 702 includes a processor 704, memory 706, a removable storage 718, and a non-removable storage 720. The computing system 702 additionally includes a bus 714 and a network interface 716. As shown in **FIG. 7**, the computing system 702 includes access to the computing system environment 700 that includes one or more user input devices 722, one or more output devices 724, and one or more communication connections 726 such as a network interface card and/or a universal serial bus connection.

Exemplary user input devices 722 include a digitizer screen, a stylus, a trackball, a keyboard, a keypad, a mouse and the like. Exemplary output devices 724 include a display unit of the personal computer, a mobile device, and the like. Exemplary communication connections 726 include a local area network, a wide area network, and/or other network.

The memory 706 further includes volatile memory 708 and non-volatile memory 710. A variety of computer-readable storage media are stored in and accessed from the memory elements of the computing system 702, such as the volatile memory 708 and the non-volatile memory 710, the removable storage 718 and the non-removable storage 720. The memory elements include any suitable memory device(s) for storing data and machine-readable instructions, such as read only memory, random access memory, erasable programmable read only memory, electrically erasable programmable read only memory, hard drive, removable media drive for handling compact disks, digital video disks, diskettes, magnetic tape cartridges, memory cards, Memory Sticks^{™}, and the like.

The processor 704, as used herein, means any type of computational circuit, such as, but not limited to, a microprocessor, a microcontroller, a complex instruction set computing microprocessor, a reduced instruction set computing microprocessor, a very long instruction word microprocessor, an explicitly parallel instruction computing microprocessor, a graphics processor, a digital signal processor, or any other type of processing circuit. The processor 704 also includes embedded controllers, such as generic or programmable logic devices or arrays, application specific integrated circuits, single-chip computers, smart cards, and the like.

Embodiments of the present subject matter may be implemented in conjunction with program modules, including functions, procedures, data structures, and application programs, for performing tasks, or defining abstract data types or low-level hardware contexts. Machine-readable instructions stored on any of the above-mentioned storage media may be executable by the processor 704 of the computing system 702. For example, a computer program 712 includes machine-readable instructions capable of generating the axially structured volume mesh for simulating the design components according to the teachings and herein described embodiments of the present subject matter. In one embodiment, the computer program 712 is included on a compact disk-read only memory (CD-ROM) and loaded from the CD-ROM to a hard drive in the non-volatile memory 710. The machine-readable instructions cause the computing system 702 to encode according to the various embodiments of the present subject matter.

As shown, the computer program 712 includes a volume mesh generation module 728. For example, the volume mesh generation module 728 can be in the form of instructions stored on a non-transitory computer-readable storage medium. The non-transitory computer-readable storage medium having the instructions that, when executed by the computing system 702, causes the computing system 702 to perform the method described in **FIG. 1****.**

In one embodiment, the volume mesh generation module 728 generates an axially structured volume mesh having hexahedral cells on boundary layers of a design component and wedges and/or polyhedral cells along length of remaining part of the design component. In one example implementation, the volume mesh generation module 728 generates a structured quad mesh on a surface of the design component. In one example, the volume mesh generation module 728 identifies node pairs along opposite edges of the design component. The opposite edges include equal number of nodes. The volume mesh generation module 728 then generates the structured quad mesh having structured quad shells on the surface of the design component using the identified nodes pairs.

Further in this example implementation, the volume mesh generation module 728 extrudes the structured quad mesh radially inwards towards the axis of the design component to form the boundary layers with hexahedral cells. In one example, the volume mesh generation module 728 extrudes faces of the structured quad shells radially inwards towards the axis of the design component such that the boundary layers with the hexahedral cells are formed.

Furthermore, the volume mesh generation module 728 generates a triangular or mixed type surface mesh at a source face of an unmeshed part of the design component. In addition, the volume mesh generation module 728 extrudes the triangular or mixed type surface mesh along length of the design component starting from the source face to form the wedges and/or polyhedral cells in the unmeshed part of the design component. The process of generating the axially structured volume mesh for simulating fluid flow in the design component is explained in more detail with reference to **FIG. 1****.**

In various embodiments, the systems and methods described in **FIGS. 1** through **7** propose a technique of generating an axially structured volume mesh for simulating a design component. The proposed technique generates the axially structured volume mesh having hexahedral cells on boundary layers of the design component and wedges and/or polyhedral cells along length of remaining part of the design component. Thus providing a mesh having structured-ness in axial flow direction in the design component. Also, the boundary layer is adhered to near wall region of the design component.

Although certain methods, systems, apparatus, and articles of manufacture have been described herein, the scope of coverage of this patent is not limited thereto. To the contrary, this patent covers all methods, apparatus, and articles of manufacture fairly falling within the scope of the appended claims either literally or under the doctrine of equivalents.

### Supplement Information:

16. The non-transitory computer-readable storage medium of claim 15, wherein generating the axially structured volume mesh having hexahedral cells on the boundary layers of the design component, comprises:
   generating a structured quad mesh on a surface of the design component; and
   extruding the structured quad mesh radially inwards towards the axis of the design component to form the boundary layers with hexahedral cells.
17. The non-transitory computer-readable storage medium of claim 16, wherein generating the structured quad mesh on the surface of the design component, comprises:
   identifying node pairs along opposite edges of the design component, wherein the opposite edges comprise equal number of nodes; and
   generating the structured quad mesh having structured quad shells on the surface of the design component using the identified nodes pairs.
18. The non-transitory computer-readable storage medium of claim 17, wherein extruding the structured quad mesh radially inwards towards the axis of the design component to form the boundary layers with hexahedral cells, comprises:
   extruding faces of the structured quad shells radially inwards towards the axis of the design component such that the boundary layers with hexahedral cells are formed.
19. The non-transitory computer-readable storage medium of claim 16, wherein generating the axially structured volume mesh having wedges and/or polyhedral cells along the length of remaining part of the design component, comprises:
   generating a triangular or mixed type surface mesh at a source face of an unmeshed part of the design component; and
   extruding the triangular or mixed type surface mesh along the length of the design component starting from the source face to form the wedges and/or polyhedral cells in the unmeshed part of the design component.
20. The non-transitory computer-readable storage medium of claim 19, wherein the mixed type surface mesh generated at the source face of the unmeshed part of the design component comprises triangles, quadrilaterals and poly type shells.
21. The non-transitory computer-readable storage medium of claim 15, wherein the design component comprises ducts or bends with uniform or non-uniform cross-sectional areas.

## Claims

1. A computer implemented method of generating an axially structured volume mesh for simulating a design component, comprising:
generating the axially structured volume mesh having hexahedral cells on boundary layers of the design component and wedges and/or polyhedral cells along length of remaining part of the design component.

2. The computer implemented method of claim 1, wherein generating the axially structured volume mesh having hexahedral cells on the boundary layers of the design component, comprises:
generating a structured quad mesh on a surface of the design component; and
extruding the structured quad mesh radially inwards towards the axis of the design component to form the boundary layers with hexahedral cells.

3. The computer implemented method of claim 2, wherein generating the structured quad mesh on the surface of the design component, comprises:
identifying node pairs along opposite edges of the design component, wherein the opposite edges comprise equal number of nodes; and
generating the structured quad mesh having structured quad shells on the surface of the design component using the identified nodes pairs.

4. The computer implemented method of claim 3, wherein extruding the structured quad mesh radially inwards towards the axis of the design component to form the boundary layers with hexahedral cells, comprises:
extruding faces of the structured quad shells radially inwards towards the axis of the design component such that the boundary layers with hexahedral cells are formed.

5. The computer implemented method of claim 2, wherein generating the axially structured volume mesh having wedges and/or polyhedral cells along the length of remaining part of the design component, comprises:
generating a triangular or mixed type surface mesh at a source face of an unmeshed part of the design component; and
extruding the triangular or mixed type surface mesh along the length of the design component starting from the source face to form the wedges and/or polyhedral cells in the unmeshed part of the design component.

6. The computer implemented method of claim 5, wherein the mixed type surface mesh generated at the source face of the unmeshed part of the design component comprises triangles, quadrilaterals and poly type shells.

7. The computer implemented method of claim 1, wherein the design component comprises ducts or bends with uniform or non-uniform cross-sectional areas.

8. A system of generating an axially structured volume mesh for simulating a design component, comprising:
a processor; and
a memory coupled to the processor, wherein the memory comprises a volume mesh generation module to:
generate the axially structured volume mesh having hexahedral cells on boundary layers of the design component and wedges and/or polyhedral cells along length of remaining part of the design component.

9. The system of claim 8, wherein the volume mesh generation module generates a structured quad mesh on a surface of the design component and wherein the volume mesh generation module extrudes the structured quad mesh radially inwards towards the axis of the design component to form the boundary layers with hexahedral cells.

10. The system of claim 9, wherein the volume mesh generation identifies node pairs along opposite edges of the design component, wherein the opposite edges comprise equal number of nodes and wherein the volume mesh generation module generates the structured quad mesh having structured quad shells on the surface of the design component using the identified nodes pairs.

11. The system of claim 10, wherein the volume mesh generation module extrudes faces of the structured quad shells radially inwards towards the axis of the design component such that the boundary layers with hexahedral cells are formed.

12. The system of claim 9, wherein the volume mesh generation module generates a triangular or mixed type surface mesh at a source face of an unmeshed part of the design component and wherein the volume mesh generation module extrudes the triangular or mixed type surface mesh along the length of the design component starting from the source face to form the wedges and/or polyhedral cells in the unmeshed part of the design component.

13. The system of claim 12, wherein the mixed type surface mesh generated at the source face of the unmeshed part of the design component comprises triangles, quadrilaterals and poly type shells.

14. The system of claim 8, wherein the design component comprises ducts or bends with uniform or non-uniform cross-sectional areas.

15. A non-transitory computer-readable storage medium including instructions executable by a computing system to:
generate an axially structured volume mesh having hexahedral cells on boundary layers of a design component and wedges and/or polyhedral cells along length of remaining part of the design component.
